(19) Europäisches Patentamt
European Patent Office
Office européen des brevets

(11) **EP 0 833 347 B1**

(12) **EUROPEAN PATENT SPECIFICATION**

(45) Date of publication and mention
of the grant of the patent:
**28.12.2005 Bulletin 2005/52**

(51) Int Cl.⁷: **G11C 27/00**

(21) Application number: **96830498.0**

(22) Date of filing: **30.09.1996**

(54) **Programmable reference voltage source, particulary for analog memories**

Programmierbare Referenzspannungsquelle, insbesondere für Analogspeicher

Source de tension de référence programmable, en particulier pour mémoires analogues

(84) Designated Contracting States:
**DE FR GB IT**

(43) Date of publication of application:
**01.04.1998 Bulletin 1998/14**

(73) Proprietor: **STMicroelectronics S.r.l.**
**20041 Agrate Brianza (Milano) (IT)**

(72) Inventors:
 • **Kramer, Alan c/o STMicroelectronics S.r.l.**
 **20041 Agrate Brianza (IT)**
 • **Canegallo, Roberto**
 **15057 Tortona (IT)**
 • **Chinosi, Mauro**
 **20090 Cologno Monzese (IT)**
 • **Gozzini, Giovanni**
 **25036 Palazzolo sull'Oglio (IT)**
 • **Rolandi, Pier Luigi**
 **15059 Monleale (IT)**
 • **Sabatini, Marco**
 **25100 Brescia (IT)**

(74) Representative: **Cerbaro, Elena et al**
**STUDIO TORTA S.r.l.,**
**Via Viotti, 9**
**10121 Torino (IT)**

(56) References cited:
WO-A-93/11541          US-A- 4 181 980
US-A- 4 627 027        US-A- 5 289 401

 • ELECTRONICS LETTERS, vol. 27, no. 11, 23 May 1991, pages 924-926, XP000213694 FUJITA O ET AL: "CHARACTERISTICS OF FLOATING GATE DEVICE AS ANALOGUE MEMORY FOR NEURAL NETWORKS"
 • IBM TECHNICAL DISCLOSURE BULLETIN, vol. 21, no. 6, November 1978, NEW YORK US, pages 2349-2351, XP002026638 R M MORTON: "Analog memory array"

**Description**

The present invention relates to a programmable reference voltage source, particularly for analog memories.

As is known, for performing complex processing functions, analog memories with cells capable of memorizing analog or digital multibit values are currently being studied, for which use is advantageously made of nonvolatile floating-gate cells, particularly flash-EEPROMs, in which the value to be memorized is related to the threshold voltage of the cell. To read the cells and/or perform calculating operations, a number of voltage references are required; the references must be programmable to achieve a high degree of flexibility as regards use of the memories, to enable uniform design of memories to be used for various applications and in particular for various analog values to be stored, and to enable the reference voltages to be modified even during operation of the memory, according to the functions to be performed.

According to one known solution described in US Patent US-A-5,126,967, the reference (and data) cells are read via a sample-and-hold circuit, this solution, however, fails to provide for fast read times when memorizing a large number of voltage levels.

US-A-5, 289, 401 discloses an analog storage device for artificial neural network system, wherein an electrically erasable programmable transistor is employed as one memory cell. The memory cell is read via a reading circuit comprising a monitoring transistor and an operational amplifier, the monitoring transistor having its floating gate formed integral with that of the memory cell transistor for monitoring a change in the threshold voltage of the memory cell transistor, and its source electrode coupled to a constant current source, and the operational amplifier having its inverting input coupled to the source electrode of the monitoring transistor, noninverting input coupled to receive an externally applied voltage of a given magnitude, and an output coupled to the control gate electrode of the monitoring transistor and supplying a constant voltage independent of variations of the threshold voltage of the monitoring transistor.

US-A-4,181,980 discloses a method and apparatus for the acquisition and storage of analog signals, wherein an MOS device with a floating gate and a conductively connected gate is operated in that pulses are applied to the latter gate to capacitively charge the floating gate, the drain potential is compared in-between pulses with the analog signal, and pulse application is stopped when agreement has been reached.

It is an object of the present invention to provide a reference voltage source capable of supplying programmable reference voltages with a high degree of precision and low access time.

According to the present invention, there is provided a programmable reference voltage source, particularly for analog memories, as claimed in Claim 1.

A preferred, non-limiting embodiment of the present invention will be described by way of example with reference to the accompanying drawings, in which:

Figure 1 shows a simplified electric diagram of the reference source according to the present invention;

Figure 2 shows one possible application, in an analog memory, of the source according to the invention.

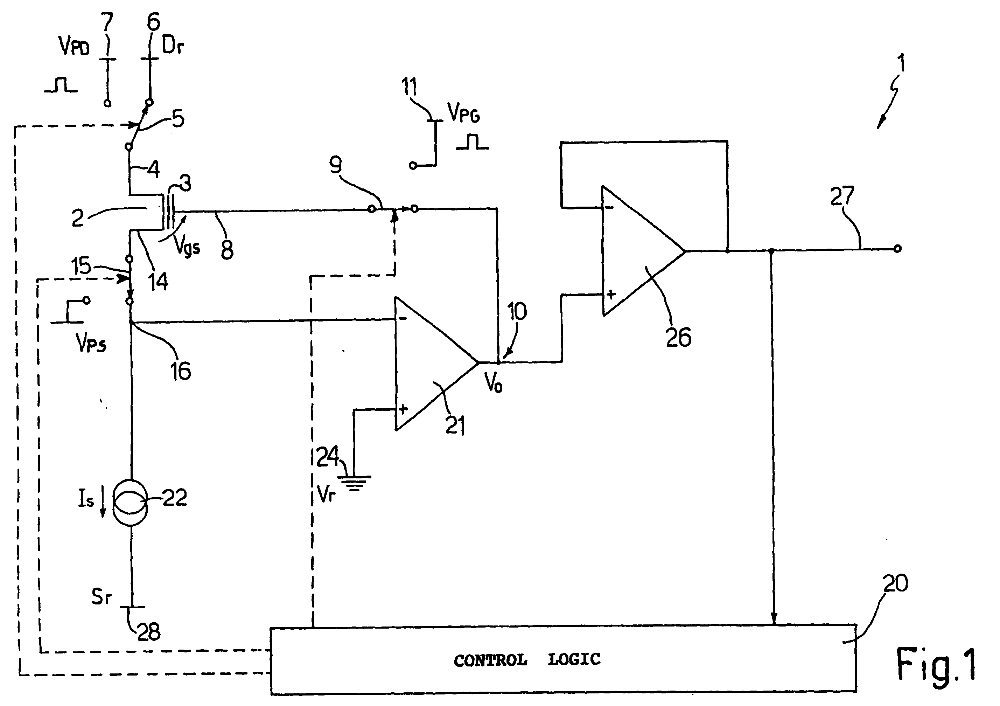

In the Figure 1 circuit, indicated as a whole by 1, a nonvolatile memory cell 2 - more specifically, a flash cell - comprises a floating-gate region 3 (shown schematically) in which is stored an electric charge defining the threshold voltage $V_{th}$ of the cell; a drain terminal 4 connected to a switch 5, which connects drain terminal 4, in a first position, to a reference potential line 6 at voltage $D_r$, and, in a second position, to a first programming line 7 at voltage $V_{PD}$; a gate terminal 8 connected to a switch 9, which connects gate terminal 8, in a first position, to a node 10, and, in a second position, to a second programming line 11 at voltage $V_{PG}$ ; and a source terminal 14 connected to a switch 15, which connects source terminal 14, in a first position, to a node 16, and, in a second position, to a voltage $V_{PS}$, which, in the case of programming, equals 0 V (ground line). The control terminals of switches 5, 9, 15 (shown only schematically in Figure 1) are controlled by a control logic circuit 20.

Node 16 is connected to the inverting input of a first operational amplifier 21, and to one terminal of a current source 22; first operational amplifier 21 has the noninverting input connected to a reference line 24 at voltage $V_r$ (e.g. ground), and the output connected to node 10 at voltage $V_o$; the output of first operational amplifier 21 is connected to the noninverting input of a second full-feedback operational amplifier 26 (inverting input connected to output 27) operating as a buffer; and current source 22 - generating current $I_s$ - has the second terminal connected to a reference line 28 at voltage $S_r$ lower than voltage $V_r$. More specifically, if voltage $V_r$ is 0 V (ground line), voltage $S_r$ is negative, e.g. -250 mV.

The Figure 1 circuit operates as follows. To begin with, switches 5, 9 and 15 are assumed to be in the positions shown; and the gate voltage (measured with respect to ground) able to cause the cell 2 to draw the current $I_s$ set by current source 22 is defined as the threshold $V_{TH}$ of cell 2.

The current $I_D$ circulating in cell 2 is approximately given by the equation:

$$I_D = K(V_{gs}-V_{th})^2 \qquad (1)$$

where K is a constant depending on the fabrication method, $V_{gs}$ is the gate-source voltage drop, and $V_{th}$ is the threshold voltage at which the cell starts turning on (at theoretically zero current).

In the circuit shown, as current $I_D$ in the cell must equal the current $I_s$ set by source 22 ($I_D = I_s$), the overdrive voltage $V_{ov} = V_{gs} - V_{th}$ of the cell is fixed. Moreover, when $V_r = 0$ V and in equilibrium, voltage $V_s$ at source terminal 14 of the cell, set by the closed-loop connection of operational amplifier 21, is also zero, so that output voltage $V_o$ of first operational amplifier 21 - equal to the gate voltage of cell 2 measured with respect to ground - equals voltage drop $V_{gs}$ of the cell, i.e. threshold voltage $V_{th}$ of the cell plus the overdrive voltage $V_{ov}$ determined in (1). As such:

$$V_o = V_{ov} + V_{th}$$

so that, according to the above definition of threshold $V_{TH}$, it follows that $V_o = V_{TH}$.

Second operational amplifier 26 supplies voltage $V_o$ at output 27, and is capable of driving even high resistive/capacitive loads, so that output 27 presents an analog voltage of a value equal to the programmed threshold $V_{TH}$ of the cell, which may be set and modified by altering the amount of charge stored in floating-gate region 3 of cell 2.

Programming of cell 2 is controlled by control logic circuit 20, which determines program pulse duration by controlling the position of switches 5, 9, 15, and decides when programming is to be interrupted. More specifically, to program cell 2, control logic circuit 20 connects its drain, gate and source terminals 5, 8 and 14 respectively to line 7, line 11 and $V_{PS}$ (ground) for a predetermined time interval; then switches switches 5, 9 and 15 to the positions shown in Figure 1; reads the voltage $V_o$ reached by cell 2 at node 10 or output 27 (as shown in Figure 1) and compares it with the desired programming value to determine whether the programming procedure is to be terminated or whether a further programming step is to be performed by again switching switches 5, 9, 15.

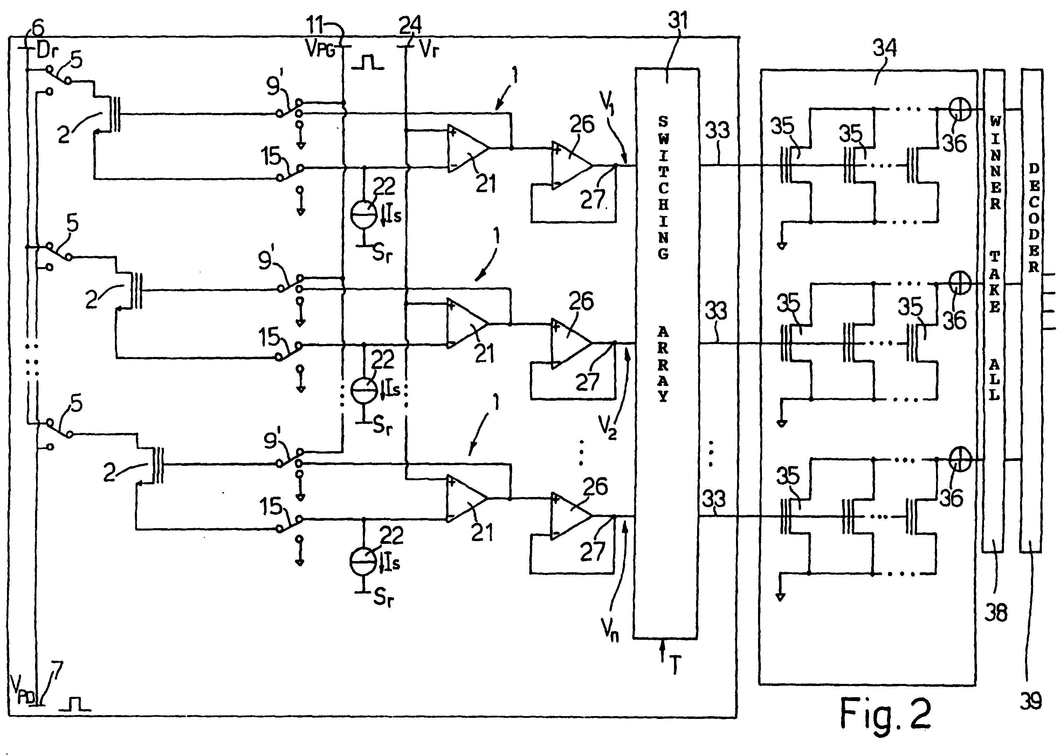

An example of application of the source according to the invention in an analog memory for calculating the distance between vectors comprising a number of input values and vectors comprising a number of stored values is shown in Figure 2, the general architecture of which is known to experts in the field (see, for example, "Ultra-Low-Power Analog Associative Memory Core Using Flash-EEPROM-Based Programmable Capacitors," by A. Kramer, R. Canegallo, M. Chinosi, D. Doise, G. Gozzini, P.L. Rolandi, M. Sabatini, P. Zabberoni, ISLPD '95 Symposium Proceedings, p. 203-208).

The Figure 2 configuration, which provides for calculating euclidean distance, shows a reference array 30 comprising a number of circuits 1, each comprising a respective cell 2 memorizing a different threshold value, and each formed as shown in Figure 1, except that, to prevent undesired soft writing phenomena, the switches (here indicated 9') connected to the gate terminals of cells 2 have a third position for grounding the gate terminals of the cells not meant for programming (only one cell being programmed at a time).

The outputs of circuits 1 - supplying voltages $V_1$, $V_2$, ..., $V_n$ equal to the different memorized thresholds $V_{TH}$ - are supplied to any type of switching array 31 (e.g. as described in a co-pending patent application filed concurrently and entitled " Input structure, in particular for analog or digital associative memories") which, on the basis of a control signal T generated by control logic circuit 20 (not shown in Figure 2), connects one or more nodes 27 to one or more word lines 33 of a memory array 34 comprising flash cells 35 of the same type as cells 2, and each memorizing a different threshold voltage.

More specifically, cells 35 are arranged in rows and columns; the cells in the same row have the gate terminals connected to the same word line 33, all the drain terminals connected together to an adding element 36, all the source terminals grounded together; and adding nodes 36 (formed in known manner (not shown), e.g. by means of an operational amplifier fedback through a resistor) are connected to a known "winner-take-all" circuit 38 in turn connected at the output to a decoding circuit 39.

In the Figure 2 device, the output voltages $V_1$-$V_n$ at nodes 27 are selectively supplied by switching array 31 to the gate terminals of cells 35 to determine the difference between the value of the vector supplied over word lines 33 and the vectors stored in cells 35; nodes 36 add the currents flowing in all of cells 35 in the same row; "winner-take-all" circuit 38 selects the row corresponding to the minimum value at adding nodes 36; and decoder 39 outputs the digital decoding of the selected row.

The advantages of the circuit described are as follows. In particular, it provides for analog references programmable according to a specific application by means of a simple, easy-to-integrate structure formed using the same technology as the analog circuits using the references; and programmability of the cell threshold voltage provides for freely and repeatedly modifying the output reference.

Moreover, if the output voltage is used as a reference for memory cells of the same type as the circuit cell, the voltage supplied is temperature-compensated. That is, any variation in threshold voltage $V_{th}$ of cell 2 due to temperature is supplied, via operational amplifiers 21, 26, to the memory cells to be read (35 in Figure 2). As these, however, present the same variation in threshold voltage, the overdrive remains substantially constant. More specifically, if $V_t$ is the threshold voltage, and $V_i$ the gate-source voltage of the i-th cell 35, its overdrive voltage equals $V_{ov} = V_i - V_t$. If threshold $V_t$ of cells 35 increases by $\Delta V$ due to a variation in temperature ($V_t$

' = $V_t + \Delta V$), threshold $V_{th}$ of cells 2 also increases by $\Delta V$. Since the overdrive voltage of cells 2 is fixed by current $I_s$, the output voltage to circuits 1, applied to the gate terminals of cells 35, increases by the same amount, i.e.: $V_{i'} = V_i + \Delta V$, so that the overdrive voltage $V_{ov}'$ of cells 35 may be expressed as follows:

$$V_{ov'} = V_{i'} - V_{t'} = V_i + \Delta V - (V_t + \Delta V) = V_i - V_t = V_{ov}$$

The circuit described is highly precise, and, should precision be impaired by drift, may easily be reprogrammed to maintain predetermined levels of precision. Moreover, consumption is low (in the order of μA) and the circuit may also be used in low-power (e.g. portable) electronic devices.

Cells 2 may be programmed and erased using the same configuration as in Figure 1, by appropriately biasing the terminals.

Clearly, changes may be made to the circuit as described and illustrated herein without, however, departing from the scope of the present invention, as defined in the appended claims. In particular, the biasing value of the drain terminal of the cell may be selected as required, and the noninverting terminal of amplifier 21 may be biased at any constant voltage, while the ground connection preventing the body effect (which, as is known, causes the threshold value of the cell to depend also on the voltage between the source and body regions of the cell). Changes may be made to the programming procedure and programming circuit, which do not form part of the invention. The current source may be formed in any known manner (e.g. by means of MOS transistors or current mirrors), and the circuit may be used for any application requiring on-chip programmable voltage references. In the case of a reference array, and if only one reference voltage at a time is required, as opposed to forming a number of separate circuits 1, only cells 2 need be duplicated using a single operational amplifier 21 and respective buffer 26 with appropriate switching devices.

**Claims**

1. A programmable reference voltage source (1), in particular for analog memories, comprising a nonvolatile memory cell (2) having a drain terminal (4), a gate terminal (8), a source terminal (14), and a floating gate region (3) storing electric charges determining a threshold value programmed in said nonvolatile memory cell (2); and programming means (5, 9, 15) connected to said drain, source and gate terminals (4, 8, 14) of said nonvolatile memory cell (2) to program a desired threshold value; **characterized by** reading means (21, 26) connected to said gate and source terminals (8, 14) of said nonvolatile memory cell (2) to read the threshold value programmed therein, said reading means (21, 26) comprising an operational amplifier (21) having a first input connected, during reading of said memory cell (2), to said source terminal (14) of said nonvolatile memory cell (2), a second input connected to a first constant voltage line (24), and an output connected, during reading of said memory cell (2), to said gate terminal (8) of said nonvolatile memory cell (2) and configured to provide the threshold value programmed therein; and by control means (20) configured to receive the threshold value programmed in said nonvolatile memory cell (2) from said operational amplifier (21) and to control operation of said programming means (5, 9, 15) based on said programmed threshold value, so as to program said desired threshold value in said nonvolatile memory cell (2).

2. A programmable reference voltage source as claimed in claim 1, wherein said programming means (5, 15) comprise first switching means (5) for selectively connecting said drain terminal (4) of said nonvolatile memory cell (2) to a second constant voltage line (6) or to a first programming voltage line (7); second switching means (9) for selectively connecting said gate terminal (8) of said nonvolatile memory cell (2) to said output (10) of said operational amplifier (21) or to a second programming voltage line (11); and third switching means (15) for selectively connecting said source terminal (14) of said nonvolatile memory cell (2) to said first input (16) of said operational amplifier (21) or to a reference potential line ($V_{PS}$); said control means (20) being configured to generate control signals for said first, second and third switching means (5, 9, 15).

3. A programmable reference voltage source as claimed in claim 2, further comprising first and second biasing means (6, 22) for biasing said drain terminal (4) and, respectively, said source terminal (14) of said nonvolatile memory cell (2).

4. A programmable reference voltage source as claimed in claim 3, wherein said first biasing means comprise said second constant voltage line (6), and said second biasing means comprise a constant current source (22).

5. A programmable reference voltage source as claimed in claim 4, wherein said constant current source (22) has a first terminal connected to said first input (16) of said operational amplifier (21), and a second terminal connected to a third constant voltage line (28) set at a lower potential than that of said first constant voltage line (24).

6. A programmable reference voltage source as claimed in any one of the foregoing claims, wherein said nonvolatile memory cell (2) is a flash-EEPROM cell.

7. A programmable reference voltage source as claimed in any one of the foregoing claims 2 to 6, further comprising a buffer element (26) connected to said output of said operational amplifier (21).

8. A programmable reference voltage source as claimed in claim 7, wherein said buffer element comprises a full-feedback operational amplifier (26).

**Patentansprüche**

1. Eine programmierbare Referenzspannungsquelle (1), insbesondere für analoge Speicher, die Folgendes aufweist: Eine nichtflüchtige Speicherzelle (2) mit einem Drain-Anschluss (4), einen Gate-Anschluss (8), einem Source-Anschluss (14) und einem schwimmenden Gate-Bereich (3), der elektrische Ladungen speichert, die einen Schwellenwert bestimmen, der in der nichtflüchtigen Speicherzelle (2) programmiert ist; und
Programmiermittel (5, 9, 15), die mit den Drain-, Source- und Gate-Anschlüssen (4, 8, 14) der nichtflüchtigen Speicherzelle (2) verbunden sind, um einen gewünschten Schwellenwert zu programmieren; **gekennzeichnet durch** Lesemittel (21, 26), die mit den Gate- und Source-Anschlüssen (8, 14) der nichtflüchtigen Speicherzelle (2) verbunden sind, um den darin programmierten Schwellenwert zu lesen, wobei die Lesemittel (21, 26) einen Operationsverstärker (21) aufweisen mit einem ersten Eingang, der während des Lesens der Speicherzelle (2) mit dem Source-Anschluss (14) der nichtflüchtigen Speicherzelle (2) verbunden ist, einem zweiten Eingang, der mit einer ersten konstanten Spannungsleitung (24) verbunden ist und einen Ausgang, der während des Lesens der Speicherzelle (2) mit dem Gate-Anschluss (8) der nichtflüchtigen Speicherzelle (2) verbunden ist und konfiguriert ist zum Vorsehen des darin programmierten Schwellenwerts; und
**durch** Steuermittel (20), die konfiguriert sind zum Empfangen des in der nichtflüchtigen Speicherzelle (2) programmierten Schwellenwerts von dem Operationsverstärker (21) und zum Steuern des Betriebs der Programmiermittel (5, 9, 15) basierend auf dem programmierten Schwellenwert, um den gewünschten Schwellenwert in die nichtflüchtige Speicherzelle (2) zu programmieren.

2. Programmierbare Referenzspannungsquelle nach Anspruch 1, wobei die Programmiermittel (5, 15) erste Schaltmittel (5) aufweisen zum selektiven Verbinden des Drain-Anschlusses (4), der nichtflüchtigen Speicherzelle (2) mit einer zweiten konstanten Spannungsleitung (6) oder mit einer ersten Programmierspannungsleitung (7); zweite Schaltmittel (9) zum selektiven Verbinden des Gate-Anschlusses (8) der nichtflüchtigen Speicherzelle (2) mit dem Ausgang (10) des Operationsverstärkers (21) oder mit einer zweiten Programmierspannungsleitung (11); und dritte Schaltmittel (15) zum selektiven Verbinden des Source-Anschlusses (14) der nichtflüchtigen Speicherzelle (2) mit dem ersten Ausgang (16) des Operationsverstärkers (21) oder mit einer Referenzspannungsleitung ($V_{PS}$); wobei die Steuermittel (20) konfiguriert sind zum Erzeugen von Steuersignalen für die ersten, zweiten und dritten Schaltmittel (5, 9, 15).

3. Programmierbare Referenzspannungsquelle nach Anspruch 2, die ferner Folgendes aufweist: Erste und zweite Vorspannmittel (6, 22) zum Vorspannen des Drain-Anschlusses (4) bzw. des Source-Anschlusses (14) der nichtflüchtigen Speicherzelle (2).

4. Programmierbare Referenzspannungsquelle nach Anspruch 3, wobei die ersten Vorspannmittel die zweite konstante Spannungsleitung (6) aufweist und die zweiten Vorspannmittel eine konstante Stromquelle (22) aufweisen.

5. Programmierbare Referenzspannungsquelle nach Anspruch 4, wobei die konstante Stromquelle (22) einen ersten Anschluss besitzt, der mit dem ersten Eingang (16) des Operationsverstärkers (21) verbunden ist, und einen zweiten Anschluss, der mit einer dritten konstanten Spannungsleitung (28) verbunden ist, die auf eine niedrigere Spannung eingestellt ist, als die der ersten konstanten Spannungsleitung (24).

6. Programmierbare Referenzspannungsquelle nach einem der vorhergehenden Ansprüche, wobei die nichtflüchtige Speicherzelle (2) eine Flash-EEPROM-Zelle ist.

7. Programmierbare Referenzspannungsquelle nach einem der vorhergehenden Ansprüche 2 bis 6, die ferner ein Pufferelement (26) aufweist, das mit dem Ausgang des Operationsverstärkers (21) verbunden ist.

8. Programmierbare Referenzspannungsquelle nach Anspruch 7, wobei das Pufferelement einen Vollrückkopplungsoperationsverstärker (26) aufweist.

**Revendications**

1. Source de tension de référence programmable (1), en particulier pour des mémoires analogiques, comportant une cellule de mémoire non volatile (2) ayant une borne de drain (4), une borne de grille (8), une borne de source (14), et une région de grille flottante (3) stockant des charges électriques déterminant une valeur de seuil programmée dans ladite cellule de mémoire non volatile (2) ; et des moyens de programmation (5, 9, 15) connectés audites bornes de drain, de source et de grille (4, 8, 14) de ladite cellule de mémoire non volatile (2) pour programmer une valeur de seuil voulue ; **caractérisé par** des moyens de lecture (21, 26) connectés auxdites bornes de grille et de source (8, 14) de ladite cellule de mémoire non volatile (2) pour lire la valeur de seuil programmée dans celle-ci, lesdits moyens de lecture (21, 26) comportant un amplificateur opérationnel (21) ayant une première entrée connectée, durant la lecture de ladite cellule de mémoire (2), à ladite borne de source (14) de ladite cellule de mémoire non volatile (2), une deuxième entrée connectée à une première ligne de tension constante (24), et une sortie connectée, durant la lecture de ladite cellule de mémoire (2), à ladite borne de grille (8) de ladite cellule de mémoire non volatile (2) et configurée pour fournir la valeur de seuil programmée dans celle-ci ; et par des moyens de commande (20) configurés pour recevoir dudit amplificateur opérationnel (21) la valeur de seuil programmée dans ladite cellule de mémoire non volatile (2) et pour commander le fonctionnement desdits moyens de programmation (5, 9, 15) sur la base de ladite valeur de seuil programmée, de manière à programmer ladite valeur de seuil voulue dans ladite cellule de mémoire non volatile (2).

2. Source de tension de référence programmable selon la revendication 1, dans laquelle lesdits moyens de programmation (5, 15) comportent des premiers moyens de commutation (5) pour sélectivement connecter ladite borne de drain (4) de ladite cellule de mémoire non volatile (2) à une deuxième ligne de tension constante (6) ou à une première ligne de tension de programmation (7) ; des deuxièmes moyens de commutation (9) pour sélectivement connecter ladite borne de grille (8) de ladite cellule de mémoire non volatile (2) à ladite sortie (10) dudit amplificateur opérationnel (21) ou à une deuxième ligne de tension de programmation (11) ; et des troisièmes moyens de commutation (15) pour sélectivement connecter ladite borne de source (14) de ladite cellule de mémoire non volatile (2) à ladite première entrée (16) dudit amplificateur opérationnel (21) ou à une ligne de potentiel de référence ($V_{PS}$) ; lesdits moyens de commande (20) étant configurés pour générer des signaux de commande pour lesdits premiers, deuxièmes et troisièmes moyens de commutation (5, 9, 15).

3. Source de tension de référence programmable selon la revendication 2, comportant de plus des premiers et deuxièmes moyens de polarisation (6, 22) pour polariser ladite borne de drain (4) et, respectivement, ladite borne de source (14) de ladite cellule de mémoire non volatile (2).

4. Source de tension de référence programmable selon la revendication 3, dans laquelle lesdits premiers moyens de polarisation comportent ladite deuxième ligne de tension constante (6), et lesdits deuxièmes moyens de polarisation comportent une source de courant constant (22).

5. Source de tension de référence programmable selon la revendication 4, dans laquelle ladite source de courant constant (22) a une première borne connectée à ladite première entrée (16) dudit amplificateur opérationnel (21), et une deuxième borne connectée à une troisième ligne de tension constante (28) réglée à un potentiel inférieur à celui de ladite première ligne de tension constante (24).

6. Source de tension de référence programmable selon l'une quelconque des revendications précédentes, dans laquelle ladite cellule de mémoire non volatile (2) est une cellule EEPROM-flash.

7. Source de tension de référence programmable selon l'une quelconque des revendications 2 à 6 précédentes, comportant de plus un élément tampon (26) connecté à ladite sortie dudit amplificateur opérationnel (21).

8. Source de tension de référence programmable selon la revendication 7, dans laquelle ledit élément tampon comporte un amplificateur opérationnel à contre-réaction complète (26).

Fig.1

EP 0 833 347 B1

Fig. 2

EP 0 833 347 B1